# EUROPÄISCHE PATENTSCHRIFT

(11) **EP 2 839 500 B1**
(45) Veröffentlichungstag und Bekanntmachung des Hinweises auf die Patenterteilung: **05.06.2019**
(21) Anmeldenummer: 13726028.7
(22) Anmeldetag: 16.04.2013
(51) Int. Cl.: H01J 37/32, H05H 1/46

(54) **MIKROWELLENPLASMAERZEUGUNGSVORRICHTUNG UND VERFAHREN ZU DEREN BETRIEB**
MICROWAVE PLASMA GENERATING DEVICE AND METHOD FOR OPERATING THE SAME
DISPOSITIF GÉNÉRATEUR DE PLASMA MICRO-ONDES ET PROCÉDÉ POUR LE FAIRE FONCTIONNER

(30) Priorität: 19.04.2012 DE 102012103425
(43) Veröffentlichungstag der Anmeldung: 25.02.2015
(73) Patentinhaber: Meyer Burger (Germany) GmbH, 09337 Hohenstein-Ernstthal (DE)
(72) Erfinder: MAI, Joachim, 04603 Nobitz (DE); SCHLEMM, Hermann, 07743 Jena (DE)
(74) Vertreter: Steiniger, Carmen
(86) Internationale Anmeldenummer: PCT/IB2013/053006
(87) Internationale Veröffentlichungsnummer: WO 2013/156924

(56) Entgegenhaltungen:
- DE-A1- 4 136 297
- DE-A1- 19 722 272
- DE-A1-102006 048 815
- DE-A1-102008 036 766
- DE-B3-102010 027 619

## Beschreibung

Die vorliegende Erfindung betrifft eine Mikrowellenplasmaerzeugungsvorrichtung mit einer Plasmakammer, wenigstens einer außerhalb der Plasmakammer vorgesehenen Mikrowellenerzeugungsvorrichtung zur Erzeugung von Mikrowellen und einer Mikrowelleneinkoppelvorrichtung, mit der die Mikrowellen in die Plasmakammer einkoppelbar sind, wobei die Mikrowelleneinkoppelvorrichtung einen durch wenigstens eine Kammerwand der Plasmakammer in die Plasmakammer führenden Innenleiter, ein den Innenleiter einschließendes und den Innenleiter von einem Innenraum der Plasmakammer abtrennendes Isolierrohr und einen durch die wenigstens eine Kammerwand in die Plasmakammer führenden, koaxial, aber nicht um den gesamten Umfang des Innenleiters vorgesehenen und in der Plasmakammer wenigstens ein Außenleiter-Ende aufweisenden Außenleiter aufweist, wobei der Innenleiter und der Außenleiter eine Mikrowellenleitung ausbilden und in der Plasmakammer ein Austritt von Mikrowellen aus der Mikrowellenleitung zur Erzeugung eines Mikrowellenplasmas in dem Innenraum der Plasmakammer vorgesehen ist. Die Erfindung betrifft ferner ein Verfahren zum Betreiben einer solchen Mikrowellenplasmaerzeugungsvorrichtung.

Mikrowellenplasmaerzeugungsvorrichtungen der genannten Gattung sind aus dem Stand der Technik beispielsweise aus der Druckschrift DE 41 36 297 A1 bekannt. Die beschriebene Mikrowellenplasmaerzeugungsvorrichtung dient zur lokalen Erzeugung eines Plasmas in einer Behandlungskammer für Substrate. Dabei ist die verwendete Mikrowelleneinkoppelvorrichtung durch einen in der Kammerwand der Plasmakammer vorgesehenen Flansch hindurchgeführt. Die beschriebene Mikrowelleneinkoppelvorrichtung weist einen äußeren Führungshohlleiter aus isolierendem Material auf, in dem ein Innenleiter aus Metall verläuft, wobei die Mikrowellen von einer Mikrowellenerzeugungsvorrichtung in den Innenleiter eingekoppelt werden. Die Ausbreitung der Mikrowelle erfolgt als koaxialer Wellentyp vorzugsweise im Zwischenraum zwischen dem Innenleiter und dem erzeugten Plasma. Dabei breiten sich die Mikrowellen in dem Führungshohlleiter gemäß den Gesetzen koaxialer Wellenleiter weiter aus, wobei das umgebende Plasma die Funktion des Außenleiters übernimmt. Durch Abschirmung des Führungshohlleiters an definierten Bereichen kann die auf der Oberfläche des Rohres entstehende Plasmazone auf gewünschte Bereiche konzentriert werden. In einem solchen Fall wird der äußere Mantel des Führungshohlleiters aus Metall ausgebildet und übernimmt hierdurch die Funktion des Außenleiters und verhindert in dieser Zone ein Austreten von Mikrowellen in die evakuierten Bereiche der Behandlungskammer, wo ansonsten ein Plasma erzeugt werden würde.

Mit einer solchen Mikrowellenplasmaerzeugungsvorrichtung können durch die hohe erzeugbare Plasmadichte effektive Plasmabearbeitungen durchgeführt werden. Die Mikrowellenplasmaerzeugungsvorrichtungen können gepulst oder kontinuierlich betrieben werden. Bei einer Pulsung der Mikrowellenleistung können die Pulse sowohl phasengleich oder auch definiert phasenversetzt zueinander eingestellt werden. Weiter ist auch aus der Druckschrift DE 10 2008 036 766 A1 bekannt in einer Mikrowellenplasmaerzeugungsvorichtung eine zusätzliche Elektrode einzusetzen um eine anodische Oxidation durchzuführen. Dabei können dickere Schichten erzeugt werden.

Beispielsweise können plasmaunterstützte CVD-Abscheidungen mit hohen Abscheideraten realisiert werden. Typisch für plasmagestützte CVD-Abscheidungen mit Mikrowellenplasmen ist, dass die Ionenenergie der auf die Schicht einwirkenden Ionen relativ gering ist. Das kann bei sensiblen Substratoberflächen sehr vorteilhaft sein, führt aber mitunter zu einer geringeren Schichtqualität zum Beispiel dann, wenn bei hohen Abscheideraten gleichzeitig sehr dichte Schichten erreicht werden sollen. Eine bekannte Möglichkeit zur Steigerung der Schichtdichte besteht in der Erhöhung der lonenenergien durch eine die Ionen beschleunigende elektrische Substratvorspannung. Allerdings erweist sich die zuverlässige Einstellung der gewünschten Substratvorspannung in der Praxis insbesondere bei bewegten Substratträgern und Substraten als schwierig.

Es ist daher die Aufgabe der Erfindung, ein einfaches Verfahren zur Abscheidung qualitativ hochwertiger Schichten bei einer hohen Abscheiderate und eine entsprechende Anlagentechnik zur Ausführung dieses Verfahrens vorzuschlagen.

Die Aufgabe wird in einem Aspekt der Erfindung durch eine Mikrowellenplasmaerzeugungsvorrichtung der eingangs genannten Gattung gelöst, wobei in dem Innenraum der Plasmakammer, koaxial zu dem Innenleiter wenigstens eine gegenüber der Kammerwand elektrisch isolierte und mit einer DC-, NF- oder HF-Spannung beaufschlagbare Plasmaelektrode vorgesehen ist, mit welcher das Mikrowellenplasma elektrisch kontaktierbar ist, sodass dem Mikrowellenplasma zumindest teilweise die Funktion des Außenleiters übertragbar ist. Dabei wird erfindungsgemäß unter einer DC-Spannung eine Gleichspannung, unter einer NF-Spannung eine niederfrequente Spannung, das heißt eine Spannung mit einer Frequenz von 20 bis 20000 Hz, und unter einer HF-Spannung eine hochfrequente Spannung, das heißt eine Spannung einer Frequenz von 3 MHz bis ca. 300 GHz, verstanden.

Der Außenleiter einer mit großen elektrischen Leistungen betriebenen Mikrowellenleitung ist vorzugsweise elektrisch geerdet. Durch die Erdung werden ein einfacher technischer Aufbau und eine große Betriebssicherheit der erfindungsgemäßen Mikrowellenplasmaerzeugungsvorrichtung erreicht.

In der erfindungsgemäßen Mikrowellenplasmaerzeugungsvorrichtung endet der Außenleiter im Inneren der Plasmakammer an dem wenigstens einen Außenleiter-Ende. An das Außenleiter-Ende anschließend ist das Mikrowellenplasma als elektrischer Leiter vorgesehen, wobei das Mikrowellenplasma die Aufgabe des Außenleiters bei der Mikrowellenleitung zumindest teilweise übernimmt. Das Außenleiter-Ende kann um den gesamten Umfang der Mikrowelleneinkoppelvorrichtung oder nur um einen Teil des Umfangs der Mikrowelleneinkoppelvorrichtung vorgesehen sein. Jedenfalls ist ab dem Außenleiter-Ende der Außenleiter zumindest teilweise unterbrochen, sodass in dem unterbrochenen Bereich durch den Außenleiter selbst keine Abschirmung mehr zur Verfügung gestellt wird, die ein Austreten von Mikrowellen aus dem Innenleiter in den Innenraum der Plasmakammer verhindern könnte. Das Mikrowellenplasma dient nach dem Außenleiter-Ende in der linearen Mikrowellenplasmaerzeugungsvorrichtung als Ersatz für den dort fehlenden Außenleiter.

Letzteres geschieht dadurch, dass dann, wenn das Plasma der erfindungsgemäßen Mikrowellenerzeugungsvorrichtung die Cut-Off-Dichte erreicht, dieses Plasma zum hochleitfähigen Koaxial-Außenleiter der Mikrowellenerzeugungsvorrichtung wird. Wenn dieses hochdichte Plasma isoliert zu einer möglichen "Masse"-Umgebung angeordnet wird, kann dieses Plasma als neue Elektrode für ein Niederdruckplasma verwendet werden. Dafür ist bei der erfindungsgemäßen Mikrowellenplasmaerzeugungsvorrichtung die Verschlusstechnik am Isolierrohr der Mikrowellenerzeugungsvorrichtung isoliert gegenüber Masse aufgebaut und die Plasmaelektrode, die der Kontaktierung des Mikrowellenplasmas dient, mit einer äußeren Spannungsquelle verbunden.

Jedes erzeugte Plasma bildet zu den mit ihm in Wechselwirkung stehenden beziehungsweise einschließenden Wänden ein Plasmarandschichtpotenzial aus. Die Plasmaelektrode kann deshalb keinen wirklichen ohmschen Kontakt zum Mikrowellenplasma ausbilden. Es ist deshalb wichtig, dass die koppelnde Plasmaelektrodenfläche ausreichend groß bemessen wird, um einen gewünschten Ladungsträgerstrom zum Substrat einstellen zu können.

Die Plasmaelektrode ist bei der erfindungsgemäßen Mikrowellenerzeugungsvorrichtung um den Außenleiter, in der Nähe des Außenleiter-Endes vorgesehen. Diese Plasmaelektrode ist gegenüber der Kammerwand und gegenüber dem Außenleiter elektrisch isoliert und kann mit einer DC-, NF- oder HF-Spannung beaufschlagt werden. In der erfindungsgemäßen Mikrowellenplasmaerzeugungsvorrichtung werden somit die elektrischen Eigenschaften des Mikrowellenplasmas nicht nur durch die über die Mikrowellenleitung eingeleiteten Mikrowellen, sondern auch über die an die Plasmaelektrode angelegte DC-, NF- oder HF-Spannung bestimmt.

Als Spannungsversorgungen der Plasmaelektroden können Gleichspannungen oder Wechselspannungen verwendet werden. Die Spannungsversorgungen können dabei entweder kontinuierlich oder gepulst betrieben werden. Der Frequenzbereich der Wechselspannungen liegt vorteilhaft zwischen ca. 50 Hz und 13,56 MHz. Die konkrete Auswahl erfolgt dabei nach den technologischen Erfordernissen und ist nicht auf den angegebenen Frequenzbereich beschränkt. Bei bestimmten Anwendungen kann es vorteilhaft sein, wenn auch die Mikrowellenerzeugungsvorrichtungen und die Spannungsversorgungen der Plasmaelektrode zeitlich zueinander definiert betrieben werden können. Damit kann zum Beispiel in zeitlicher Abfolge der Substratbearbeitung ein lonenbeschuss mit hoher lonenenergie oder mit niedriger lonenenergie eingestellt werden.

Bei herkömmlichen, aus dem Stand der Technik bekannten Mikrowellenplasmaerzeugungsvorrichtungen schließt sich das Mikrowellenplasma meist direkt an den geerdeten Außenleiter an beziehungsweise steht in intensiver Wechselwirkung mit umliegenden Wänden, die sich auf Erdpotenzial befinden, und weist deshalb auch selbst ein Potenzial in der Nähe des Erdpotenzials auf. Dadurch kann das Mikrowellenplasma, selbst mit einer zusätzlichen Plasmaelektrode, nicht auf ein höheres Plasmapotenzial angehoben werden. Erfindungsgemäß wird dieser Nachteil dadurch behoben, dass das Mikrowellenplasma konsequent von umgebenden und geerdeten Wänden isoliert wird und dann an die Plasmaelektrode eine DC-, NF- oder HF-Spannung angelegt wird, sodass die Potenzialdifferenz zwischen Mikrowellenplasma und Substrat vergrößert wird und Ionen aus dem Mikrowellenplasma mit größerer Energie auf die Substrate auftreffen. Die damit einstellbare lonenenergie erlaubt beispielsweise eine Erhöhung der Schichtdichte der abgeschiedenen Schichten und ermöglicht die Überwindung energetischer Barrieren bei Ausheilvorgängen in der Schicht. Die Plasmaelektrode ist ein stationärer Bestandteil der erfindungsgemäßen Mikrowellenplasmaerzeugungsvorrichtung. Die Plasmaelektrode kann deshalb einfach und zuverlässig elektrisch angeschlossen werden.

Mit der Plasmaelektrode wird ein ähnlicher technischer Effekt wie mit einer Substratvorspannung erzielt, die Lösung mit der Plasmaelektrode ist jedoch zuverlässiger und zudem einfach.

Das erfindungsgemäß verwendete Mikrowellenplasma zeichnet sich durch eine einfache lineare Skalierbarkeit aus. Gegenüber niederfrequenteren Anregungsfrequenzen können Mikrowellen-Plasmen sehr hohe Plasmadichten erreichen und sind deshalb besonders für Hochrateprozesse geeignet. Zudem ist es durch die erfindungsgemäße Überlagerung des Mikrowellenplasmas mit einer Niederfrequenz- oder Hochfrequenzentladung möglich, gegenüber der Bezugsmasse ein variierbares Randschichtpotenzial einzustellen. Damit kann die Energie stoßender Ionen mit der Substratoberfläche in einem gewissen Umfang frei eingestellt werden. Da das gebildete Mikrowellenplasma der erfindungsgemäßen Mikrowellenplasmaerzeugungsvorrichtung immer am Außendurchmesser der Mikrowelleneinkoppelvorrichtung erzeugt wird, ist auch immer eine hochleitfähige Elektrode vorhanden, die die Rolle einer neuen Elektrode gegenüber der Bezugsmasse übernehmen kann. Das ist auch dann so, wenn isolierende Beschichtungen am dielektrischen Isolierrohr der Mikrowellenkoppelvorrichtung aufwachsen.

Vorzugsweise ist in der erfindungsgemäßen Mikrowellenplasmaerzeugungsvorrichtung, die als eine lineare Plasmaquelle ausgebildet ist, der wenigstens eine Außenleiter im Bereich der Kammerwand geerdet. Die Kammerwand und der Außenleiter können somit aus Metallen, welche geerdet sind, bestehen. Für die erfindungsgemäße Mikrowellenplasmaerzeugungsvorrichtung ergibt sich ein besonders einfacher Aufbau, wenn die Verbindungsstelle des Außenleiters mit der Kammerwand auf Erdpotenzial liegt. Der Außenleiter kann in diesem Fall einfach montiert werden, beispielsweise mit Hilfe einer Schweiß- oder Schraubverbindung. Der Außenleiter muss jedoch nicht unbedingt im Bereich der Kammerwand geerdet sein, der Außenleiter kann beispielsweise auch gegenüber einer leitenden Kammerwand isoliert oder in einer isolierenden Kammerwand befestigt sein.

In einer anderen Variante der erfindungsgemäßen Mikrowellenplasmaerzeugungsvorrichtung kann der Außenleiter auch mit einer Spannungsversorgung verbunden sein. Dabei müsste der Außenleiter mit einer Wechselspannung höherer Frequenz versorgt und sonst gegenüber Masse isoliert werden. In diesem Fall könnte über den innerhalb des Isolierrohres befindlichen Außenleiter eine dielektrische Kopplung des Mikrowellenplasmas erfolgen. Dabei würde der wenigstens eine Außenleiter die erfindungsgemäße Funktion der Plasmaelektrode erfüllen und die Plasmaelektroden könnten grundsätzlich entfallen.

In einer vorteilhaften Ausbildung der erfindungsgemäßen Mikrowellenplasmaerzeugungsvorrichtung ist der wenigstens eine Außenleiter innerhalb des Isolierrohres angeordnet. Die Plasmakammer muss regelmäßig gegenüber der Umwelt abgeschlossen betrieben werden. Das heißt, die Plasmakammer muss auch im Bereich der Mikrowellenleitung abgedichtet werden. Das Isolierrohr ist eine vorteilhafte Lösung für eine solche Abdichtung. Rohre sind generell stabile Bauelemente bei mechanischer Belastung durch Druckdifferenzen von innen nach außen und folglich für den Einsatz in der erfindungsgemäßen Mikrowellenplasmaerzeugungsvorrichtung gut geeignet.

Durch die Anordnung des Außenleiters innerhalb des Isolierrohres ist dieser von dem Mikrowellenplasma räumlich getrennt und es findet keine Schichtabscheidung oder sonstige Plasmaeinwirkung auf den Außenleiter statt. Das Isolierrohr wirkt in dieser Lösung als räumliche Trennung und gleichzeitig als Austrittsfenster für die Mikrowellen von dem Inneren des Isolierrohres in den außerhalb des Isolierrohres befindlichen Innenraum der Plasmakammer.

Gemäß einer günstigen Variante der erfindungsgemäßen Mikrowellenplasmaerzeugungsvorrichtung ist das wenigstens eine Außenleiter-Ende ein gerades Rohrende. In dieser Ausbildung bildet das Mikrowellenplasma im Anschluss an das Außenleiter-Ende einen hohlzylinderförmigen Außenleiter um den Innenleiter herum aus. Das Mikrowellenplasma befindet sich also in diesem Fall nicht nur substratseitig gegenüber dem Innenleiter, sondern auch auf der dem Substrat abgewandten Seite des Innenleiters. Eine solche Mikrowellenplasmaerzeugungsvorrichtung ist beispielsweise in Plasmabearbeitungsprozessen von Vorteil, in denen eine lange Verweildauer von Gasmolekülen in dem Mikrowellenplasma vorteilhaft ist.

In einer alternativen Ausgestaltung der erfindungsgemäßen Mikrowellenplasmaerzeugungsvorrichtung ist der Außenleiter rohrförmig mit wenigstens einer sich in der Längsrichtung des Außenleiters erstreckenden Streifenöffnung ausgebildet. In dieser Ausbildung weist der rohrförmige Außenleiter eine sich in Längsrichtung desselben erstreckende Öffnung auf, die eine streifenförmige Ausnehmung in dem hohlzylinderförmigen Außenleiter ist. Durch die Breite und Länge des oder der Streifen kann das Dämpfungsmaß der Mikrowelle in der Mikrowellenleitung beeinflusst werden. Der Streifen kann zudem räumlich zwischen dem Innenleiter und dem mit der Mikrowellenplasmaerzeugungsvorrichtung zu behandelnden Substrat angeordnet werden, sodass das Mikrowellenplasma vorteilhaft in der Nähe eines gewünschten Ortes der direkten Plasmabearbeitung lokalisiert ist.

In einem besonders geeigneten Ausführungsbeispiel der erfindungsgemäßen Mikrowellenplasmaerzeugungsvorrichtung bildet die Kammerwand, zumindest abschnittsweise, den Außenleiter aus. Der Außenleiter ist nicht in jedem Fall als ein einfaches mechanisches Bauteil, wie beispielsweise ein Rohr, zu verstehen. Mitunter, beispielsweise im Bereich von Mikrowellenverteilungen, kann der Außenleiter auch mechanisch komplex aus verschiedenen Teilen zusammengesetzt sein. Die Kammerwand kann beispielsweise in diesen Fällen als einfache und kostengünstige Befestigungsmöglichkeit für Außenleiter-Teile verwendet werden und dabei auch abschnittsweise selbst den Außenleiter ausbilden.

Gemäß einer bevorzugten Option der erfindungsgemäßen Mikrowellenplasmaerzeugungsvorrichtung ist die Mikrowellenleitung durch zwei einander gegenüber liegende Kammerwände durchgeführt, wobei in der Plasmakammer an den gegenüber liegenden Kammerwänden zwei einander gegenüber liegende Plasmaelektroden angeordnet sind, zwischen denen die Ausbildung des Mikrowellenplasmas vorgesehen ist. In dieser Ausbildung der Erfindung wird das Mikrowellenplasma in den Außenbereichen der Plasmakammer durch zwei Plasmaelektroden kontaktiert.

Zur Vermeidung der Ausbildung von undefinierten Plasmen im Bereich der Plasmaelektroden werden diese nach dem Stand der Technik mit einer Dunkelraumabschirmung versehen. Dabei ist zu beachten, dass das Mikrowellenplasma selbst keinen wesentlichen Kontakt zu geerdeten Bauteilen der Dunkelraumabschirmung hat.

Im Zentrum der Plasmakammer erstreckt sich das Mikrowellenplasma unterbrechungsfrei über einen großen Teil der Breite der Plasmakammer. Mit dem ununterbrochenen Mikrowellenplasma ist es möglich, einen großen Bereich homogener Plasmabearbeitung zu realisieren. Über die zwei Durchführungen durch zwei Kammerwände kann die Mikrowelleneinkoppelvorrichtung einfach und sicher an den Kammerwänden befestigt werden. Wenn die Mikrowelleneinkoppelvorrichtung ein geschlossenes, an den Kammerwänden abgedichtetes Rohr aufweist, kann durch das Rohr des Weiteren ein Medium, beispielsweise ein Kühlmedium, geleitet werden. In anderen Ausbildungen kann die Mikrowelleneinkoppelvorrichtung jedoch auch nur durch eine Kammerwand durchgeführt sein und in dem Innenraum der Plasmakammer enden.

In einer vorteilhaften Ausbildung der Mikrowellenplasmaerzeugungsvorrichtung ist die wenigstens eine Plasmaelektrode rohrförmig ausgebildet, wobei jeweils ein Rohrende der Plasmaelektrode als elektrischer Kontakt zu dem Mikrowellenplasma vorgesehen ist. Die rohrförmige Ausbildung der Plasmaelektrode ist besonders einfach. Die rohrförmigen Plasmaelektroden können sowohl in Kombination mit vollumfänglichen als auch in Kombination mit verschiedenen teilumfänglichen Außenleiter-Enden verwendet werden.

In einer einfachen Ausführungsform der Erfindung kann das Rohrende der Plasmaelektrode gerade ausgebildet sein. Es ist jedoch auch möglich, dass das Rohrende der Plasmaelektrode einen Radius besitzt, der sich stetig, stufenartig oder diskontinuierlich vergrößert. Dadurch sind unterschiedliche kontaktierende Flächenbereiche der Plasmaelektroden zum Mikrowellenplasma erreichbar.

In einer Alternative zu der eben beschriebenen Ausbildung der erfindungsgemäßen Mikrowellenplasmaerzeugungsvorrichtung ist die Plasmaelektrode als ein durchgehendes Rohr mit wenigstens einer sich in seiner Längsrichtung erstreckenden Plasmaelektrodenöffnung in dem Mantel des Rohres ausgebildet, wobei in der wenigstens einen Plasmaelektrodenöffnung das Mikrowellenplasma vorgesehen ist. In dieser Ausbildung wird nur eine Plasmaelektrode verwendet, die folglich auch nur einmal angeschlossen werden muss. Diese Plasmaelektrode weist wenigstens eine Plasmaelektrodenöffnung auf, wobei an den Kanten der Plasmaelektrodenöffnung das Mikrowellenplasma kontaktiert wird. Alle anderen Bereiche der Plasmaelektrode werden zumindest teilweise mit einer Dunkelraumabschirmung versehen. An offenen Bereichen der Dunkelraumabschirmung können definierte Bereiche für eine Plasmaausbildung vorgesehen sein. Diese Bereiche werden dann vorwiegend mit der jeweiligen Spannung der Plasmaelektroden aufrecht erhalten.

Diese Plasmaelektrode muss selbstverständlich so montiert werden, dass die Plasmaelektrodenöffnung passend zu dem wenigstens einen Außenleiter-Ende ausgerichtet ist. Form, Größe und Lage der wenigstens einen Plasmaelektrodenöffnung ermöglichen dabei auch eine Einflussnahme auf das Mikrowellenplasma, die beispielsweise zur Einstellung einer guten Bearbeitungshomogenität entlang der linearen Ausdehnung der Mikrowellenplasmaerzeugungsvorrichtung ausgenutzt werden kann.

Vorzugsweise ist die Plasmaelektrodenöffnung zwischen dem Innenleiter und wenigstens einem von dem Mikrowellenplasma zu bearbeitenden Substrat angeordnet. Dadurch wird das Mikrowellenplasma in der Nähe des Substrates lokalisiert, sodass die zugeführte Mikrowellenleistung effektiv zur Schichterzeugung bzw. sonstigen Substratbearbeitung ausgenutzt werden kann.

In einer vorteilhaften Ausführungsform der erfindungsgemäßen Mikrowellenplasmaerzeugungsvorrichtung ist die wenigstens eine Plasmaelektrode derart zu Kammerwänden und wenigstens einem, zu bearbeitenden Substrat entfernt angeordnet, dass zwischen der Plasmaelektrode und dem wenigstens einen Substrat wenigstens ein Plasma ausbildbar ist. In dieser Weiterbildung ist die Plasmaelektrode nicht nur zur Kontaktierung des Mikrowellenplasmas geeignet, stattdessen kann in der Umgebung der Plasmaelektrode durch Anlegen einer DC-, NF- oder HF-Spannung ein Plasma betrieben werden. Dieses Plasma kann für verschiedene Zwecke, beispielsweise zur Unterstützung des Mikrowellenplasmaprozesses oder für einen von dem Mikrowellenplasmaprozess unabhängigen Reinigungsprozess, ausgenutzt werden.

In einer besonders bevorzugten Weiterbildung der eben beschriebenen Ausführungsform der erfindungsgemäßen Mikrowellenplasmaerzeugungsvorrichtung ist das Plasma als Teil des elektrischen Kontakts zwischen der Plasmaelektrode und dem Mikrowellenplasma ausbildbar. Bei der körperlichen Plasmaelektrode kann es beispielsweise durch eine auftretende Beschichtung im Dauerbetrieb zu einer Veränderung der elektrischen Kontakteigenschaften kommen. Eine solche Veränderung kann reduziert oder sogar vermieden werden, wenn das Mikrowellenplasma nicht nur über die körperliche Plasmaelektrode, sondern auch über das Plasma kontaktiert wird.

In einer weiteren Ausführungsform weist die erfindungsgemäße Mikrowellenplasmaerzeugungsvorrichtung wenigstens einen gasdurchlässigen Plasmaschirm und/oder wenigstens eine Magnetanordnung zur Formung des Mikrowellenplasmas auf. Mit dem Plasmaschirm und/oder der Magnetanordnung können verschiedene Plasmaparameter, wie beispielsweise die Plasmageometrie, die Plasmadichte und/oder die lonenverweildauer, in dem Plasma gezielt den bestehenden Anforderungen entsprechend eingestellt werden. Dadurch kann eine weitere Verbesserung der Schichtqualität und/oder eine Erhöhung der Prozesseffektivität erreicht werden.

Die Aufgabe der Erfindung wird in einem zweiten Aspekt durch ein Verfahren zum Betreiben einer Mikrowellenplasmaerzeugungsvorrichtung gelöst, wobei Mikrowellen einer außerhalb einer Plasmakammer der Mikrowellenplasmaerzeugungsvorrichtung vorgesehenen Mikrowellenerzeugungsvorrichtung mittels einer durch wenigstens eine Kammerwand in die Plasmakammer führenden Mikrowelleneinkoppelvorrichtung in die Plasmakammer eingekoppelt werden, wobei die Mikrowelleneinkoppelvorrichtung einen durch die wenigstens eine Kammerwand der Plasmakammer in die Plasmakammer führenden Innenleiter, ein den Innenleiter einschließendes und den Innenleiter von einem Innenraum der Plasmakammer abtrennendes Isolierrohr und wenigstens einen durch die wenigstens eine Kammerwand in die Plasmakammer führenden, koaxial, aber nicht um den gesamten Umfang des Innenleiters vorgesehenen und in der Plasmakammer wenigstens ein Außenleiter-Ende aufweisenden Außenleiter aufweist, wobei der Innenleiter und der Außenleiter eine Mikrowellenleitung ausbilden und in der Plasmakammer ein Austritt von Mikrowellen aus der Mikrowellenleitung zur Erzeugung eines Mikrowellenplasmas in dem Innenraum der Plasmakammer vorgesehen ist, und wobei in dem Innenraum der Plasmakammer, koaxial zu dem Innenleiter wenigstens eine gegenüber der Kammerwand elektrisch isolierte Plasmaelektrode vorgesehen ist, die mit einer DC-, NF- oder HF-Spannung beaufschlagt wird und welche das Mikrowellenplasma elektrisch kontaktiert, wobei in der Mikrowellenleitung eine Mikrowellenleistung transportiert und zu einer Ionisierung des Mikrowellenplasmas verwendet wird, sodass das Mikrowellenplasma zumindest teilweise die Funktion des Außenleiters übernimmt, wobei das elektrische Potenzial des Mikrowellenplasmas durch die DC-, NF- oder HF-Spannung an der wenigstens einen Plasmaelektrode eingestellt wird.

In diesem Verfahren wird einerseits durch das Transportieren elektrischer Mikrowellenleistung in die Plasmakammer hinein ein Mikrowellenplasma erzeugt, welches eine hohe Ladungsträgerdichte und dadurch eine große Plasmawirkung, beispielsweise eine schnelle Plasmaschichtabscheidung, bewirkt. Desweiteren wird in dem erfindungsgemäßen Verfahren dieses Mikrowellenplasma durch die wenigstens eine Plasmaelektrode elektrisch kontaktiert und mit einer DC-, NF- oder HF-Spannung gekoppelt. Dadurch wird das elektrische Potenzial des Mikrowellenplasmas gegenüber dem Substratpotenzial verschoben, sodass über die Potenzialdifferenz beschleunigte Ionen eine gewünschte Energie erhalten und beim Auftreffen auf zu behandelnde Substrate eine vorteilhafte Wirkung entfalten.

In einer günstigen Ausgestaltung des erfindungsgemäßen Verfahrens wird das elektrische Potenzial des Mikrowellenplasmas relativ zu wenigstens einem geerdeten Substrat oder relativ zu wenigstens einem auf einem Biaspotenzial liegenden Substrat eingestellt. Die Potenzialverschiebung des Mikrowellenplasmas über die Plasmaelektrode ist zunächst als alternative Maßnahme zu einer prinzipiell ähnlich wirkenden Potenzialverschiebung des Substrates gedacht. Unabhängig von der Beeinflussung des Mikrowellenplasmas über die Plasmaelektrode kann jedoch auch zusätzlich noch das Potenzial des Substrates, das auch als Biaspotenzial bezeichnet wird, eingestellt werden. Durch diese zusätzliche Option können die Potenziale des Mikrowellenplasmas und des Substrates in Bezug zueinander gebracht werden. Dabei können diese Potenziale beispielsweise vorteilhaft symmetrisch zum Erdpotenzial eingestellt werden.

Bevorzugte Ausführungsformen der vorliegenden Erfindung, deren Aufbau, Funktion und Vorteile werden im Folgenden anhand von Figuren näher erläutert, wobei
- Figur 1: schematisch ein Ausführungsbeispiel einer erfindungsgemäßen Mikrowellenplasmaerzeugungsvorrichtung in einem Querschnitt entlang ihrer linearen Ausdehnung zeigt;
- Figur 2: schematisch ein weiteres Ausführungsbeispiel einer erfindungsgemäßen Mikrowellenplasmaerzeugungsvorrichtung im Querschnitt zeigt;
- Figur 3: schematisch noch eine weitere Ausführungsvariante einer erfindungsgemäßen Mikrowellenplasmaerzeugungsvorrichtung im Querschnitt zeigt;
- Figur 4: schematisch ein nächstes Ausführungsbeispiel einer erfindungsgemäßen Mikrowellenplasmaerzeugungsvorrichtung im Querschnitt zeigt;
- Figur 5: schematisch die Mikrowellenplasmaerzeugungsvorrichtung aus Figur 4 in einem Querschnitt quer zu der linearen Ausdehnung zeigt; und
- Figur 6: schematisch eine erfindungsgemäße Mikrowellenplasmaerzeugungsvorrichtung mit zwei beidseitig von Substraten vorgesehenen Mikrowelleneinkoppelvorrichtungen zeigt.

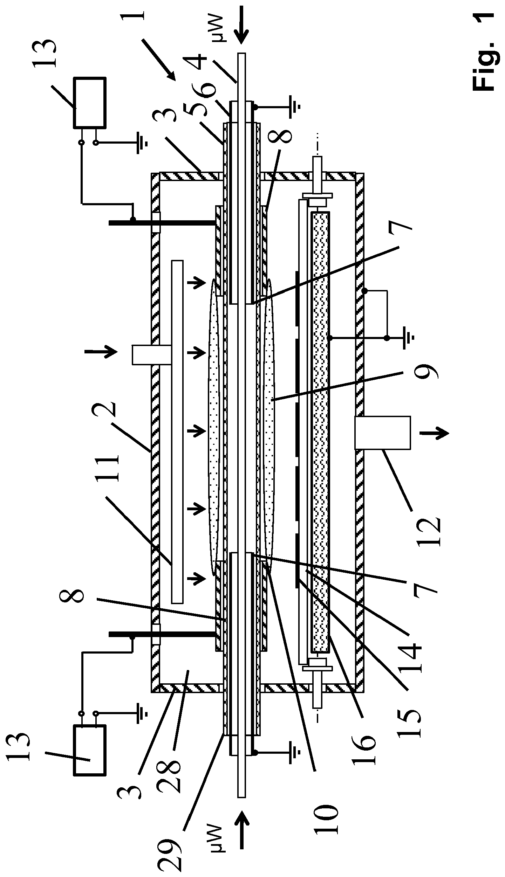

Figur 1 zeigt schematisch eine Ausführungsform einer erfindungsgemäßen Mikrowellenplasmaerzeugungsvorrichtung 1 mit einer Plasmakammer 2 in einem vertikalen Querschnitt entlang der linearen Ausdehnung der Mikrowellenplasmaerzeugungsvorrichtung 1. In der Praxis kann die erfindungsgemäße Mikrowellenplasmaerzeugungsvorrichtung 1 auch vereinfacht als Plasmaquelle bezeichnet werden.

Die Plasmakammer 2 weist einen Innenraum 28 auf, in welchen durch eine Kammerwand 3 der Plasmakammer 2 eine Mikrowelleneinkoppelvorrichtung 29 eingeführt und durch eine gegenüber liegende Kammerwand 3 aus der Plasmakammer 2 wieder herausgeführt ist. Entsprechend besitzt die Mikrowelleneinkoppelvorrichtung 29 eine lineare Abmessung, die größer als die Abmessung der Plasmakammer 2 ist.

In dem dargestellten Ausführungsbeispiel ist die Mikrowelleneinkoppelvorrichtung 29 parallel zu horizontal auf einem Substratträger 14 aufliegenden, mit der Mikrowellenplasmaerzeugungsvorrichtung 1 zu behandelnden Substraten 15 angeordnet. Der Substratträger 14 liegt in dem gezeigten Ausführungsbeispiel auf Transportrollen 27 auf und ist auf den Transportrollen 27 senkrecht zur Darstellungsebene transportierbar. In der Realität ist die Transportebene horizontal ausgerichtet.

In anderen, nicht dargestellten Ausführungsbeispielen der vorliegenden Erfindung liegen die Substrate 15 nicht horizontal auf, sondern sind anderweitig, beispielsweise in vertikaler Ausrichtung, gehaltert. In diesen nicht dargestellten Ausführungsbeispielen ist die Mikrowelleneinkoppelvorrichtung 29 entsprechend anders, beispielsweise vertikal, in der entsprechenden Plasmakammer angeordnet. Ferner kann in anderen, ebenfalls nicht gezeigten Ausführungsbeispielen der vorliegenden Erfindung eine andere Trägervorrichtung für die Substrate 15 und/oder ein anderes Transportsystem für die Substrate 15 oder neu eine einfache Halterung für die Substrate 15 verwendet werden.

Die Mikrowelleneinkoppelvorrichtung 29 ist mit einer außerhalb der Plasmakammer 2 vorgesehenen, hier nicht separat dargestellten Mikrowellenerzeugungsvorrichtung gekoppelt, die Mikrowellen µW erzeugt.

Die Mikrowelleneinkoppelvorrichtung 29 weist einen sich linear erstreckenden Innenleiter 4 auf. Der Innenleiter 4, welcher aus einem elektrisch leitfähigen Material wie Metall besteht, befindet sich innerhalb eines Isolierrohres 5, welches den Innenleiter 4 einschließt und von dem Innenraum 28 der Plasmakammer 2 abtrennt. Das Isolierrohr 5 besteht aus einem elektrisch nicht leitfähigen Material, beispielsweise einem dielektrischen Material, wie Glas oder einer Oxid-Keramik.

In der in Figur 1 dargestellten Ausführungsform der Erfindung befindet sich an den beiden Seiten der Plasmakammer 2, koaxial um den Innenleiter 4 ein Außenleiter 6 aus einem elektrisch leitfähigen Material wie einem Metall. Dabei sind der Innenleiter 4 und der Außenleiter 6 voneinander elektrisch isoliert. Der Außenleiter 6 ragt wie der Innenleiter 4 von außerhalb der Plasmakammer 2 in den Innenraum 28 der Plasmakammer 2 und endet jeweils innerhalb des Innenraumes 28 an einem Außenleiter-Ende 7. In der in Figur 1 dargestellten Ausführungsform stehen sich somit zwei Außenleiter-Enden 7 gegenüber, wobei zwischen den Außenleiter-Enden 7 koaxial um den Innenleiter 4 kein Außenleiter 6 vorgesehen ist. Da in dem Zwischenbereich zwischen den Außenleiter-Enden 7 keine elektrische Abschirmung vorhanden ist, treten in diesem Zwischenbereich die durch den Innenleiter 4 geführten Mikrowellen µW direkt vom Innenleiter 4 in den Innenraum 28 der Plasmakammer 2 aus.

Ferner ist um das Isolierrohr 5 bei der in Figur 1 dargestellten Ausführungsform der Erfindung koaxial zu dem Innenleiter 4 an beiden Seiten der Plasmakammer 2 eine jeweils im Innenraum 28 der Plasmakammer 2 endende Plasmaelektrode 8 vorgesehen, die jeweils mit einer DC-, NF- oder HF-Spannung beaufschlagbar ist. Hierfür sind die Plasmaelektroden 8 jeweils mit einer Spannungsversorgung 13 verbunden. Die dafür notwendigen Verbindungsleitungen haben innerhalb der Plasmakammer 2 eine dem Stand der Technik entsprechende Plasmaschirmung zur Vermeidung der Ausbildung von undefinierten Plasmen. Die Plasmaschirmung kann beispielsweise mit Hilfe einer Dunkelraumabschirmung realisiert werden.

Wie in Figur 1 veranschaulicht, befindet sich innerhalb des Innenraumes 28 der Plasmakammer 2 ein Mikrowellenplasma 9. Dabei bildet der Innenleiter 4 gemeinsam mit dem Außenleiter 6 eine Mikrowellenleitung zur Einleitung der Mikrowellen µW in die Plasmakammer 2 zur Speisung des Mikrowellenplasmas 9 aus. Das Mikrowellenplasma 9 erstreckt sich zwischen den Plasmaelektroden 8 um den nicht von dem Außenleiter 6 umgebenen Innenleiter 4. Dabei ist an die Plasmaelektroden 8 eine DC-, NF- oder HF-Spannung anlegbar. Die Ankopplung der NF- oder HF-Spannung von den Plasmaelektroden 8 auf das Mikrowellenplasma 9 erfolgt an elektrischen Kontakten 10. Die Plasmaelektroden 8 sollten, zumindest teilweise, mit hier nicht dargestellten Dunkelraumabschirmungen versehen werden.

Die Plasmaelektroden 8 sind in der Ausführungsform von Figur 1 als rohrförmige Elektroden ausgebildet. Zur Verbesserung der elektrischen Kontaktierung zum Mikrowellenplasma 9 kann sich der Radius der rohrförmigen Enden der Plasmaelektroden 8 zum Beispiel auch stetig, stufenartig oder auch anders funktionell in Abhängigkeit einer definierten Länge oder von definierten Längen vergrößern. Dadurch können unterschiedliche kontaktierende Flächenbereiche der Plasmaelektroden 8 zum Mikrowellenplasma 9 erreicht werden.

Im Inneren der Plasmakammer 2 übernimmt zumindest über einem Abschnitt der linearen Ausdehnung der Mikrowelleneinkoppelvorrichtung 29 das Mikrowellenplasma 9 die Funktion des Außenleiters 6. Dadurch erfolgt eine Mikrowellenleitung entlang der linearen Ausdehnung der Mikrowelleneinkoppelvorrichtung 29 trotz des Fehlens des körperlichen Außenleiters 6 in diesem Abschnitt.

In dem Ausführungsbeispiel von Figur 1 sind die beidseitig in der Plasmakammer 2 vorgesehenen Außenleiter 6 der Mikrowellenplasmaerzeugungsvorrichtung 1 als rohrförmige Außenleiter 6 ausgebildet, die geerdet sind und sich in der Plasmakammer bis zu den Außenleiter-Enden 7 erstrecken. Der Innenleiter 4 erstreckt sich hingegen in dem dargestellten Ausführungsbeispiel über die gesamte lineare Ausdehnung der Mikrowellenplasmaerzeugungsvorrichtung 1. Der Innenleiter 4 und der Außenleiter 6 bilden gemeinsam eine Wellenleitung für die in den Innenleiter 4 eingekoppelten Mikrowellen µW aus. An den Außenleiter-Enden 7 kann die Mikrowelle µW infolge des Fehlens des Außenleiters 6 aus der Mikrowellenleitung in die Plasmakammer 2 austreten.

In der Plasmakammer 2 ist darüber hinaus durch eine Gasdusche 11 eine Einleitung von Gasen in die Plasmakammer 2 vorgesehen, welche zur Ausbildung eines gewünschten Plasmas geeignet sind. Die Menge der über die Gasdusche 11 eingeleiteten Gase und der über eine Pumpleitung 12 abgeführten Gase wird so dosiert, dass in der Plasmakammer 2 ein zur Ausbildung des Mikrowellenplasmas 9 geeigneter, sich dynamisch einstellender Druck entsteht. Durch das Eindringen der Mikrowellen µW in den Innenraum 28 der Plasmakammer 2 wird das darin befindliche Gas ionisiert und es bildet sich ein elektrisch leitfähiges Mikrowellenplasma 9 aus. Das Mikrowellenplasma 9 wirkt wie ein elektrischer Leiter, der nach dem Außenleiter-Ende 7 die Funktion des fehlenden Außenleiters 6 zumindest teilweise übernimmt und eine Weiterleitung der Mikrowellen µW durch die Plasmakammer 2 bewirkt.

In der erfindungsgemäßen Mikrowellenplasmaerzeugungsvorrichtung 1 ist das Mikrowellenplasma 9 von dem Außenleiter-Ende 7 isoliert. Ein guter elektrischer Kontakt 10 besteht hingegen zu den Plasmaelektroden 8, die gegenüber den Kammerwänden 3 der Plasmakammer 2 elektrisch isoliert sind. Die Plasmaelektroden 8 sind in dem dargestellten Ausführungsbeispiel konzentrisch außerhalb der Außenleiter 6 angeordnet. Axial bezüglich der Achse der Mikrowelleneinkoppelvorrichtung 29 erstrecken sich die Plasmaelektroden 8 bis kurz vor die Außenleiter-Enden 7.

In anderen, nicht gezeigten Ausführungsvarianten der vorliegenden Erfindung ist es prinzipiell auch möglich, das Mikrowellenplasma 9 kapazitiv über die Außenleiter 6 zu koppeln. Letzteres setzt voraus, dass die Außenleiter 6 selbst isoliert gegenüber Masse sind und mit den Spannungsversorgungen 13 verbunden werden. In diesem Fall könnten die Außenleiter 6 als Plasmaelektroden 8 fungieren und die in Figur 1 dargestellten Plasmaelektroden 8 könnten entfallen. Diese Variante ist jedoch technisch sehr herausfordernd, insbesondere sind hier keine Gleichspannungsversorgungen der Außenleiter 6 möglich und selbst eine Versorgung mit Wechselspannungen ist hier auf höhere Frequenzen eingeschänkt.

In dem in Figur 1 dargestellten Ausführungsbeispiel sind die Plasmaelektroden 8 jeweils mit einer Spannungsversorgung 13, zum Beispiel mit einer HF-Quelle, verbunden. Über die von der Spannungsversorgung 13 erzeugte Spannung kann die Potenzialdifferenz zwischen dem Mikrowellenplasma 9 gegenüber den Kammerwänden 3 und gegenüber den Substraten 15 gesteuert werden. Auf diese Weise kann die Energie von Ionen, die aus dem Mikrowellenplasma 9 auf die Substrate 15 einwirken, eingestellt werden. Dadurch ist wiederum eine vorteilhafte Wirkung des Mikrowellenplasmas 9 auf die Substrate 15 erzielbar.

In dem in Figur 1 dargestellten Ausführungsbeispiel erfolgt in der Plasmakammer 2 eine plasmagestützte chemische Gasphasenabscheidung. Das Mikrowellenplasma 9 besitzt eine hohe Ionen- und Elektronendichte und bewirkt damit eine intensive Fragmentierung und Anregung des Arbeitsgases. Mit den Spannungsquellen 13 wird jeweils eine HF-Spannung erzeugt und über diese wird ein geeignet großer lonenbeschuss der abgeschiedenen Schicht sichergestellt, sodass die Schichten nicht nur mit großer Geschwindigkeit, sondern auch in hoher Qualität auf den Substraten 15 aufwachsen.

In anderen, nicht dargestellten Ausführungsbeispielen ist die Plasmakammer 2 keine Abscheidekammer, sondern eine Plasmabehandlungskammer oder eine Plasmaätzkammer.

In dem in Figur 1 dargestellten Ausführungsbeispiel sind der Substratträger 14 und die darauf aufliegenden Substrate 15 über einen Heizer 16 beheizbar. Der Heizer 16 kann je nach gewünschtem Temperaturbereich verschieden, beispielsweise als Heizplatte oder als Strahlungsheizung, ausgeführt sein.

Vorliegend ist der Heizer 16 eine geerdete Heizplatte, die gleichzeitig eine kapazitive Erdung für den Substratträger 14 und die Substrate 15 darstellt.

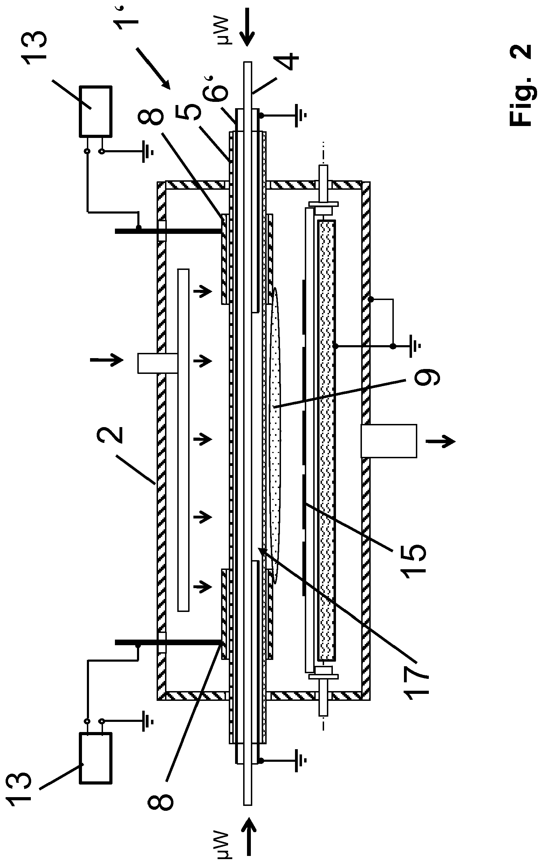

Figur 2 zeigt schematisch ein weiteres Ausführungsbeispiel der erfindungsgemäßen Mikrowellenplasmaerzeugungsvorrichtung 1' in einem Querschnitt entlang der linearen Ausdehnung dieser Mikrowellenplasmaerzeugungsvorrichtung 1'. Im Unterschied zu der Mikrowellenplasmaerzeugungsvorrichtung 1, die in Figur 1 vorgestellt wurde, erstreckt sich in diesem Ausführungsbeispiel der Außenleiter 6' in der oberen Bildhälfte durch die gesamte Plasmakammer 2. Dieser Außenleiter 6' weist nur auf der den Substraten 15 zugewandten Seite eine Streifenöffnung 17 auf. Dadurch kann die Mikrowellenleistung nicht vollumfänglich um den Innenleiter 4, sondern nur teilumfänglich aus diesem austreten. Entsprechend bildet sich das Mikrowellenplasma 9 nicht vollumfänglich um den Innenleiter 4, sondern nur teilumfänglich zwischen dem Innenleiter 4 und den Substraten 15 aus. In diesem Ausführungsbeispiel kann die eingesetzte Mikrowellenleistung für einen definierten, kleineren Volumenbereich zur Plasmaerzeugung verwendet werden, wodurch eine lokal erhöhte Ladungsträgerdichte erreicht wird. Dadurch werden die Arbeitsgase und die Mikrowellenleistung in einem stärkeren Maße zur Beschichtung der Substrate 15 als in dem Ausführungsbeispiel von Figur 1 genutzt. Die lokale erhöhte Ladungsträgerdichte in Figur 2 kann zum Beispiel für die Ausbildung eines erhöhten Ionenstroms in Richtung der Substratbearbeitung genutzt werden.

Die Ausführungsform von Figur 2 ist jedoch nicht generell günstiger als die von Figur 1. Beispielsweise kann die mit dem Mikrowellenplasma 9 von Figur 1 verbundene längere Aktivierungszeit der Gase vorteilhaft für eine Abscheidung sein.

Die Winkelausrichtung der Streifenöffnung 17 im Bezug zu den Substraten 15 kann beliebig eingestellt werden. Auch in der Figur 2 kann der Außenleiter 6 zur Plasmaelektrode werden, indem er von der Masse getrennt und mit einer Spannungsversorgung, wie der Spannungsversorgung 13, verbunden wird. Dann entfallen wiederum die in der Ausführung von Figur 2 separat vorgesehenen Plasmaelektroden 8.

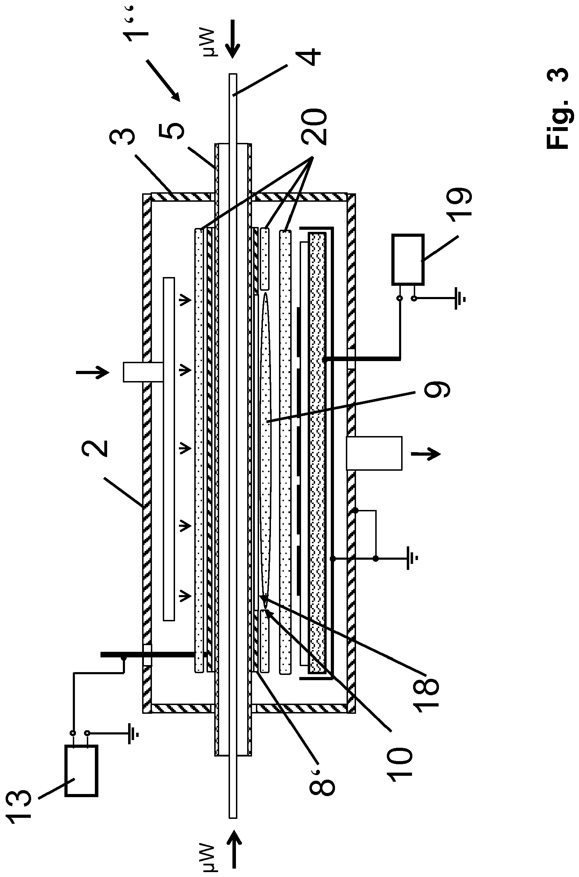

Figur 3 zeigt schematisch noch ein weiteres Ausführungsbeispiel einer erfindungsgemäßen Mikrowellenplasmaerzeugungsvorrichtung 1". Die Mikrowellenplasmaerzeugungsvorrichtung 1" weist im Unterschied zu den vorhergehenden Ausführungsbeispielen nur eine einzige Plasmaelektrode 8' auf. In dem dargestellten Ausführungsbeispiel ist die Plasmaelektrode 8' ein Rohr mit einer sich in Längsrichtung des Rohres erstreckenden Plasmaelektrodenöffnung 18. Durch die an die Plasmaelektrode 8' angelegte Spannung kann in der Plasmakammer 2 unabhängig von dem Mikrowellenplasma 9 ein Plasma 20 gezündet werden.

Die Mikrowellenplasmaerzeugungsvorrichtung 1 ist prinzipiell auch mit den Außenleitern 6 aus der Ausführungsform von Figur 1 kombinierbar. Damit wird ein Austreten von Mikrowellen im Bereich zwischen den Kammerwänden 3 und der Plasmaelektrode 8 durch das Isolierrohr 5 verhindert.

In Figur 3 ist eine erfindungsgemäße Option gezeigt, nach welcher die erfindungsgemäße Mikrowellenplasmaerzeugungsvorrichtung 1" zur Behandlung von Substraten 15 anwendbar ist, die auf eine Vorspannung legbar sind. In der Fachsprache werden die Begriffe Substratvorspannung und Substratbiasspannung als Synonyme verwendet. Zur Erzeugung der Substratbiasspannung dient der Substratbiasgenerator 19. Infolge der Substratbiasspannung kann in der Plasmakammer 2 auch das in Figur 3 vor dem Substratträger 14 skizzierte Plasma 20 ausgebildet werden.

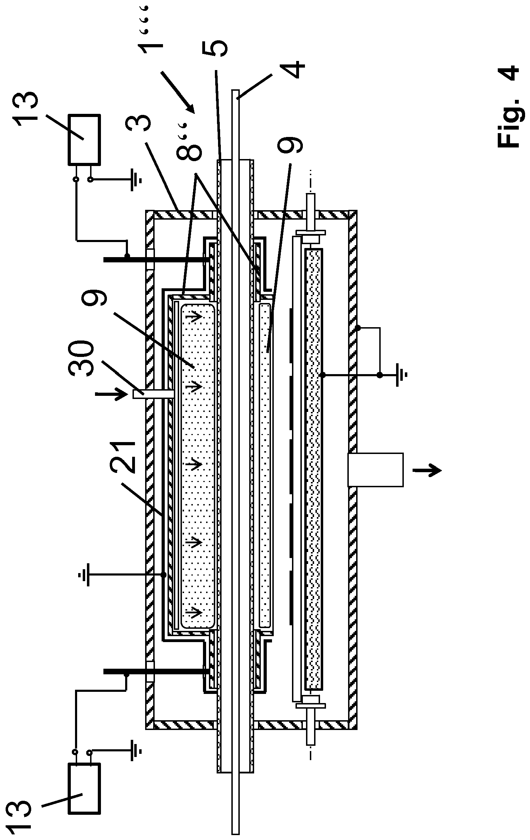

Figur 4 zeigt ein nächstes Ausführungsbeispiel einer erfindungsgemäßen Mikrowellenplasmaerzeugungsvorrichtung 1"' in einem vertikalen Querschnitt entlang der linearen Ausdehnung dieser Mikrowellenplasmaerzeugungsvorrichtung 1"'. In dieser Ausführungsform kommt eine Plasmaelektrode 8" zum Einsatz, welche eine große Oberfläche aufweist und dadurch auch größere Ladungsträgerströme aufnehmen kann. Das erzeugte Mikrowellenplasma 9 füllt den Raum zwischen der Plasmaelektrode 8" und dem Isolierrohr 5 und nimmt annähernd das Potenzial der Plasmaelektrode 8" an.

Die Mikrowellenplasmaerzeugungsvorrichtung 1"' weist eine geerdete Abschirmung 21 auf, die sich in einem kleinen Abstand zu der Plasmaelektrode 8" befindet. Der Abstand muss dabei kleiner als die Dunkelraumlänge bei den gewählten Prozessbedingungen sein, damit zwischen der Plasmaelektrode 8" und der geerdeten Abschirmung 21 kein Plasma gezündet werden kann. Die geerdete Abschirmung 21 bewirkt gemeinsam mit der Plasmaelektrode 8" eine räumliche Begrenzung des Mikrowellenplasmas 9 und dessen Trennung von den Kammerwänden 3.

Die schematisch angedeutete Gaszuführung 30 in Figur 4 muss teilweise isoliert von der Kammerwand 3 erfolgen. Vorteilhaft kann es deshalb sein, wenn die Gaszuführung 30 gleichzeitig auch als DC-, NF- oder HF-Zuführung zur Plasmaelektrode 8" genutzt wird.

Das in Figur 4 gezeigte Mikrowellenplasma 9 weist ein sehr definiertes Volumen auf, wodurch dort eingelassene Gase intensiv und effektiv abgebaut werden können. Damit wird die Mikrowellenplasmaerzeugungsvorrichtung 1"' besonders für Hochrateprozesse, mit gleichzeitig hoher lonenstromdichte zum Substrat, geeignet.

Auch die Ausführungsform von Figur 4 weist um den Innenleiter 4 von diesem elektrisch isolierte Außenleiter 6 auf. Damit wird ein definierter Mikrowellentransport bis in den Öffnungsbereich, indem das Mikrowellenplasma 9 ausgebildet werden soll, erreicht.

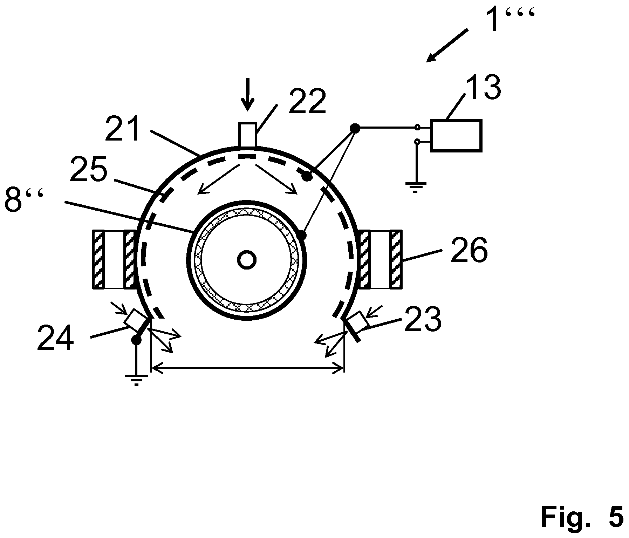

Figur 5 zeigt die Mikrowellenplasmaerzeugungsvorrichtung 1"', anders als in Figur 4 in einem Querschnitt quer zu der linearen Ausdehnung der Mikrowellenplasmaerzeugungsvorrichtung 1"'.

Die Mikrowellenplasmaerzeugungsvorrichtung 1"' weist einen Gaseinlass 22 für ein erstes Prozessgas und Gaseinlässe 23 und 24 für ein zweites Prozessgas auf. Durch die verschiedenen Einlasspositionen der Gaseinlässe 22, 23, 24 wird die Verweilzeit der eingelassenen Gase im Mikrowellenplasma 9 der linearen Mikrowellenplasmaerzeugungsvorrichtung 1"' bestimmt. Das Gas aus dem Gaseinlass 22 verweilt länger in dem Mikrowellenplasma 9 und kann dadurch stärker aktiviert und abgebaut werden, als es bei einem Einlass über die Gaseinlässe 23, 24 der Fall wäre.

Beispielsweise kann bei einer Siliziumnitridabscheidung durch den Gaseinlass 22 Ammoniak eingelassen werden und das Gas Silan kann entsprechend durch die Gaseinlässe 23 und 24 eingelassen werden. Die an die Spannungsversorgung 13 angeschlossene Plasmaelektrode 8" ist elektrisch leitend mit einem gasdurchlässigen Plasmaschirm 25 verbunden, sodass der Plasmaschirm 25 Teil der Plasmaelektrode 8" ist. Der gasdurchlässige Plasmaschirm 25 ist von der geerdeten Abschirmung 21 umgeben, wobei in dem Zwischenraum ein Dunkelraum besteht, in welchem keine Plasmaerzeugung möglich ist, aber ein ungehinderter Gastransport in den Raum zwischen Plasmaschirm 25 und Plasmaelektrode 8" stattfinden kann.

Die Mikrowellenplasmaerzeugungsvorrichtung 1"' weist desweiteren Magnetanordnungen 26 auf, welche zur Formung der Geometrie des Plasmas 20 dienen. Die Ausrichtung der Magnetpole der Magnetanordnung 26 kann so erflogen, dass sich die von den gegenüberliegenden Magnetpolen ausgehenden Magnetfelder entweder anziehend oder abstoßend ausbilden. Stehen sich zum Beispiel gleiche Magnetpole gegenüber, so werden weitreichende Magnetfelder in Richtung der Substratoberfläche ausgebildet. Das erzeugte Plasma wird dadurch in Richtung der Substratoberfläche verdichtet. Bei einer anziehenden Ausrichtung der gegenüberliegenden Magnetpole wird das erzeugte Plasma quasi in einer magnetischen Flasche, innerhalb der Mikrowellenerzeugungsvorrichtung 1"' eingeschlossen und verdichtet. Der Ladungsträgerstrom in Richtung zum Substrat 15 wird dadurch verringert. Die gegenüberliegenden Magnetanordnungen 26 können zur weiteren Formung der Magnetfelder aber auch auf andere definierte Positionen als dargestellt und entlang der geerdeten Abschirmung 21 eingerichtet werden.

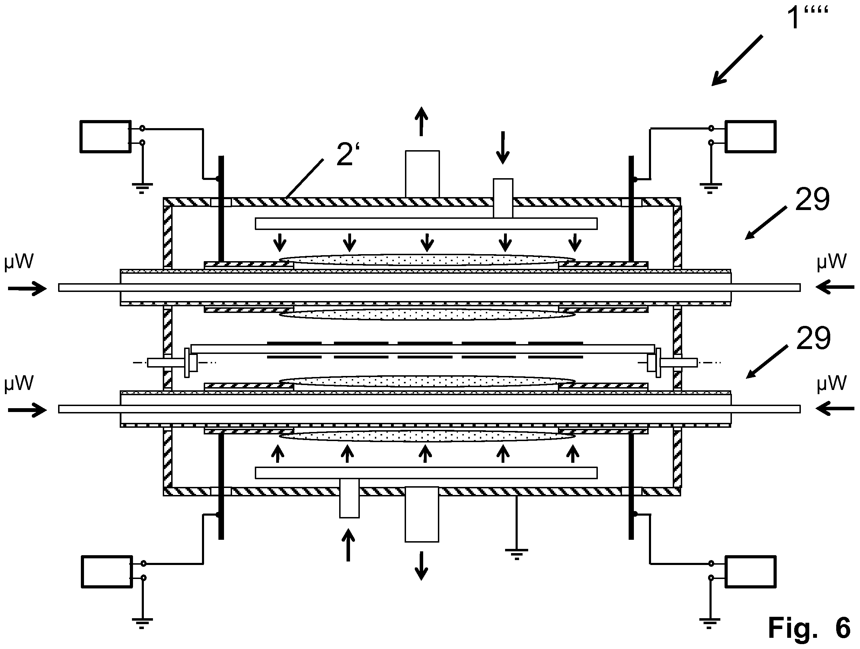

Figur 6 zeigt eine vertikale Anordnung von zwei Mikrowelleneinkoppelvorrichtungen 29 einer erfindungsgemäßen Mikrowellenplasmaerzeugungsvorrichtung 1"" beidseitig von Substraten 15 in einer Plasmakammer 2'. In der Plasmakammer 2' sind die zwei dargestellten Mikrowelleneinkoppelvorrichtungen 29 gleichzeitig aktiv, sodass pro Zeiteinheit doppelt so viele Substrate 15 als in den oben beschriebenen Mikrowellenplasmaerzeugungsvorrichtungen 1, 1', 1", 1"' bearbeitet werden können. Alternativ können in dieser Plasmakammer 2' Substrate 15 zweiseitig beschichtet werden, wobei in diesem Fall ein Substratträger verwendet werden muss, der eine Substratbeschichtung von beiden Substratseiten erlaubt.

## Patentansprüche

1. Mikrowellenplasmaerzeugungsvorrichtung (1, 1', 1", 1"', 1"") mit einer Plasmakammer (2, 2'), wenigstens einer außerhalb der Plasmakammer (2, 2') vorgesehenen Mikrowellenerzeugungsvorrichtung zur Erzeugung von Mikrowellen (µW) und einer Mikrowelleneinkoppelvorrichtung (29), mit der die Mikrowellen (µW) in die Plasmakammer (2, 2') einkoppelbar sind, wobei die Mikrowelleneinkoppelvorrichtung (29) einen durch wenigstens eine Kammerwand (3) der Plasmakammer (2, 2') in die Plasmakammer (2, 2') führenden Innenleiter (4), ein den Innenleiter (4) einschließendes und den Innenleiter (4) von einem Innenraum (28) der Plasmakammer (2, 2') abtrennendes Isolierrohr (5) und einen durch die wenigstens eine Kammerwand (3) in die Plasmakammer (2, 2') führenden, koaxial, aber nicht vollumfänglich um den gesamten Innenleiter (4) vorgesehenen und in der Plasmakammer (2, 2') wenigstens ein Außenleiter-Ende (7) aufweisenden Außenleiter (6, 6') aufweist, wobei der Innenleiter (5) und der Außenleiter (6, 6') eine Mikrowellenleitung ausbilden und in der Plasmakammer (2, 2') ein Austritt von Mikrowellen (µW) aus der Mikrowellenleitung zur Erzeugung eines Mikrowellenplasmas (9) in dem Innenraum (28) der Plasmakammer (2, 2') vorgesehen ist, wobei in dem Innenraum (28) der Plasmakammer (2, 2') wenigstens eine gegenüber der Kammerwand (3) elektrisch isolierte und mit einer DC-, NF- oder HF-Spannung beaufschlagbare Plasmaelektrode (8) vorgesehen ist, mit welcher das Mikrowellenplasma (9) elektrisch kontaktierbar ist, **dadurch gekennzeichnet dass** die Plasmaelektrode (8) koaxial zu dem Innenleiter angeordnet ist so dass dem Mikrowellenplasma (9) zumindest teilweise die Funktion des Außenleiters (6, 6') übertragbar ist.

2. Mikrowellenplasmaerzeugungsvorrichtung nach Anspruch 1, **dadurch gekennzeichnet, dass** der wenigstens eine Außenleiter (6, 6') im Bereich der Kammerwand (3) geerdet ist.

3. Mikrowellenplasmaerzeugungsvorrichtung nach Anspruch 1, **dadurch gekennzeichnet, dass** der wenigstens eine Außenleiter (6, 6') mit einer Wechselspannungsquelle (13) verbunden ist.

4. Mikrowellenplasmaerzeugungsvorrichtung nach einem der vorhergehenden Ansprüche, **dadurch gekennzeichnet, dass** der wenigstens eine Außenleiter (6, 6') innerhalb des Isolierrohres (5) angeordnet ist.

5. Mikrowellenplasmaerzeugungsvorrichtung nach Anspruch 4, **dadurch gekennzeichnet, dass** das wenigstens eine Außenleiter-Ende (7) ein gerades Rohrende ist.

6. Mikrowellenplasmaerzeugungsvorrichtung nach Anspruch 4, **dadurch gekennzeichnet, dass** der Außenleiter (6') rohrförmig mit wenigstens einer sich in der Längsrichtung des Außenleiters (6') erstreckenden Streifenöffnung (17) ausgebildet ist.

7. Mikrowellenplasmaerzeugungsvorrichtung nach Anspruch 1, 2 oder 3, **dadurch gekennzeichnet, dass** wenigstens ein Abschnitt der Kammerwand (3) einen Teil des wenigstens einen Außenleiters (6, 6') ausbildet.

8. Mikrowellenplasmaerzeugungsvorrichtung nach wenigstens einem der vorhergehenden Ansprüche, **dadurch gekennzeichnet, dass** die Mikrowellenleitung durch zwei einander gegenüber liegende Kammerwände (3) durchgeführt ist und in der Plasmakammer (2, 2') an den gegenüber liegenden Kammerwänden (3) zwei einander gegenüber liegende Plasmaelektroden (8) angeordnet sind, zwischen denen die Ausbildung des Mikrowellenplasmas (9) vorgesehen ist.

9. Mikrowellenplasmaerzeugungsvorrichtung nach wenigstens einem der vorhergehenden Ansprüche, **dadurch gekennzeichnet, dass** um die wenigstens eine Plasmaelektrode (8) eine Dunkelraumabschirmung vorgesehen ist.

10. Mikrowellenplasmaerzeugungsvorrichtung nach wenigstens einem der vorhergehenden Ansprüche, **dadurch gekennzeichnet, dass** die wenigstens eine Plasmaelektrode (8) rohrförmig ausgebildet ist, wobei jeweils ein Rohrende der Plasmaelektrode (8) als elektrischer Kontakt (10) zu dem Mikrowellenplasma (9) vorgesehen ist.

11. Mikrowellenplasmaerzeugungsvorrichtung nach Anspruch 10, **dadurch gekennzeichnet, dass** sich der Radius wenigstens eines der Rohrenden stetig, stufenartig oder diskontinuierlich vergrößert.

12. Mikrowellenplasmaerzeugungsvorrichtung nach wenigstens einem der Ansprüche 1 bis 8, **dadurch gekennzeichnet, dass** die Plasmaelektrode (8) als ein durchgehendes Rohr mit wenigstens einer sich in seiner Längsrichtung erstreckenden Plasmaelektrodenöffnung (18) in dem Mantel des Rohres ausgebildet ist, wobei in der wenigstens einen Plasmaelektrodenöffnung (18) das Mikrowellenplasma (9) vorgesehen ist.

13. Mikrowellenplasmaerzeugungsvorrichtung nach Anspruch 12, **dadurch gekennzeichnet, dass** die Plasmaelektrodenöffnung (18) zwischen dem Innenleiter (4) und wenigstens einen von dem Mikrowellenplasma (9) zu bearbeitenden Substrat (15) angeordnet ist.

14. Mikrowellenplasmaerzeugungsvorrichtung nach wenigstens einem der vorhergehenden Ansprüche, **dadurch gekennzeichnet, dass** die wenigstens eine Plasmaelektrode (8) derart zu Kammerwänden (3) und wenigstens einem zu bearbeitenden Substrat (15) entfernt angeordnet ist, dass zwischen der Plasmaelektrode (8) und dem wenigstens einen Substrat (15) ein Plasma (20) ausbildbar ist.

15. Mikrowellenplasmaerzeugungsvorrichtung nach Anspruch 14, **dadurch gekennzeichnet, dass** das Plasma (20) als Teil des elektrischen Kontakts zwischen der Plasmaelektrode (8) und dem Mikrowellenplasma (9) ausbildbar ist.

16. Mikrowellenplasmaerzeugungsvorrichtung nach wenigstens einem der vorhergehenden Ansprüche, **dadurch gekennzeichnet, dass** die Mikrowellenplasmaerzeugungsvorrichtung (1, 1', 1", 1"', 1"") wenigstens einen gasdurchlässigen Plasmaschirm (25) und/oder wenigstens eine Magnetanordnung (26) zur Formung des Mikrowellenplasmas (9) aufweist.

17. Verfahren zum Betreiben einer Mikrowellenplasmaerzeugungsvorrichtung (1, 1', 1", 1"', 1""), wobei die Mikrowellen (µW) wenigstens einer au-ßerhalb einer Plasmakammer (2, 2') der Mikrowellenplasmaerzeugungsvorrichtung (1) vorgesehenen Mikrowellenerzeugungsvorrichtung mittels wenigstens einer durch wenigstens eine Kammerwand (3) in die Plasmakammer (2, 2') führenden Mikrowelleneinkoppelvorrichtung (29) in die Plasmakammer (2, 2') eingekoppelt werden, wobei die Mikrowelleneinkoppelvorrichtung (29) einen durch die wenigstens eine Kammerwand (3) der Plasmakammer (2, 2') in die Plasmakammer (2, 2') führenden Innenleiter (4), ein den Innenleiter (4) einschließendes und den Innenleiter (4) von einem Innenraum (28) der Plasmakammer (2, 2') abtrennendes Isolierrohr (5) und wenigstens einen durch die wenigstens eine Kammerwand (3) in die Plasmakammer (2, 2') führenden, koaxial, aber nicht um den gesamten Umfang des Innenleiters (4) vorgesehenen und in der Plasmakammer (2, 2') wenigstens ein Außenleiter-Ende (7) aufweisenden Außenleiter (6, 6') aufweist, wobei der Innenleiter (5) und der Außenleiter (6, 6') eine Mikrowellenleitung ausbilden und in der Plasmakammer (2, 2') ein Austritt von Mikrowellen (µW) aus der Mikrowellenleitung zur Erzeugung eines Mikrowellenplasmas (9) in dem Innenraum (28) der Plasmakammer (2, 2') vorgesehen ist, wobei in dem Innenraum (28) der Plasmakammer (2, 2') wenigstens eine gegenüber der Kammerwand (3) elektrisch isolierte Plasmaelektrode (8) vorgesehen ist, die mit einer DC-, NF- oder HF-Spannung beaufschlagt wird und welche das Mikrowellenplasma (9) elektrisch kontaktiert, wobei in der Mikrowellenleitung eine Mikrowellenleistung transportiert und zu einer Ionisierung des Mikrowellenplasmas (9) verwendet wird, **dadurch gekennzeichnet dass** die Plasmaelektrode (8) koaxial zu dem Innenleiter angeordnet ist so dass das Mikrowellenplasma (9) zumindest teilweise die Funktion des Außenleiters (6, 6') übernimmt, wobei das elektrische Potenzial des Mikrowellenplasmas (9) durch die DC-, NF- oder HF-Spannung an der wenigstens einen Plasmaelektrode (8) eingestellt wird.

18. Verfahren nach Anspruch 17, **dadurch gekennzeichnet, dass** das elektrische Potenzial des Mikrowellenplasmas (9) relativ zu wenigstens einem geerdeten Substrat (15) oder relativ zu wenigstens einem auf einem Biaspotenzial liegenden Substrat (16) eingestellt wird.

## Claims

1. Microwave plasma generating device (1, 1', 1", 1"', 1"") with a plasma chamber (2, 2'), at least one microwave generating device for generating microwaves (µW) provided outside of the plasma chamber (2, 2'), and a microwave incoupling device (29), with which the microwaves (µW) are coupable into the plasma chamber (2, 2'), wherein the microwave incoupling device (29) comprises an inner conductor (4) which leads into the plasma chamber (2, 2') through at least one chamber wall (3) of the plasma chamber (2, 2'), an insulating tube (5) enclosing the inner conductor (4) and separating the inner conductor (4) from an interior (28) of the plasma chamber (2, 2'), and at least one outer conductor (6, 6') comprising at least one outer conductor end (7) in the plasma chamber (2, 2'), leading into the plasma chamber (2, 2') through the at least one chamber wall (3), provided coaxially but not fully around the entire inner conductor (4), wherein the inner conductor (5) and the outer conductor (6, 6') form a microwave line and an outlet of microwaves (µW) out of the microwave line in the plasma chamber is provided to generate microwave plasma (9) in the interior (28) of the plasma chamber (2, 2'), wherein in the interior (28) of the plasma chamber (2, 2'), at least one plasma electrode (8), which is electrically insulated from the chamber wall (3) and to which a DC, NF, or HF voltage can be applied, is provided, with which the microwave plasma (9) is electronically contactable,
**characterized in that** the plasma electrode (8) is arranged coaxially to the inner conductor so that the function of the outer conductor (6, 6') is transferable at least partly to the microwave plasma (9).

2. Microwave plasma generating device according to claim 1, **characterized in that** the at least one outer conductor (6, 6') is grounded in the region of the chamber wall (3).

3. Microwave plasma generating device according to claim 1, **characterized in that** the at least one outer conductor (6, 6') is connected to an alternating voltage source (13).

4. Microwave plasma generating device according to one of the preceding claims, **characterized in that** the at least one outer conductor (6, 6') is arranged inside the insulating tube (5).

5. Microwave plasma generating device according to claim 4, **characterized in that** the at least one outer conductor end (7) is a straight tube end.

6. Microwave plasma generating device according to claim 4, **characterized in that** the outer conductor (6') is tubular with at least one stripe opening (17) extending in the longitudinal direction of the outer conductor (6').

7. Microwave plasma generating device according to claim 1, 2 or 3, **characterized in that** at least one section of the chamber wall (3) forms a part of the at least one outer conductor (6, 6').

8. Microwave plasma generating device according to at least one of the preceding claims, **characterized in that** the microwave line is led through two chamber walls (3) being opposite to each other, and in the plasma chamber (2, 2'), on the chamber walls (3) being opposite to each other, two plasma electrodes (8) being opposite to each other are arranged, between which the formation of microwave plasma (9) is provided.

9. Microwave plasma generating device according to least one of the preceding claims, **characterized in that** a darkroom screen is provided around the at least one plasma electrode (8).

10. Microwave plasma generating device according to at least one of the preceding claims, **characterized in that** the at least one plasma electrode (8) is tubular, wherein one tube end of the plasma electrode (8), respectively, is provided as electrical contact (10) to the microwave plasma (9).

11. Microwave plasma generating device according to claim 10, **characterized in that** the radius of at least one of the tube ends is continuously, gradually, or discontinuously increasing.

12. Microwave plasma generating device according to at least one of the claims 1 to 8, **characterized in that** the plasma electrode (8) is formed as a continuous tube with at least one plasma electrode opening (18) extending in its longitudinal direction in the jacket of the tube, wherein the microwave plasma (9) is provided in the at least one plasma electrode opening (18).

13. Microwave plasma generating device according to claim 12, **characterized in that** the plasma electrode opening (18) is provided between the inner conductor (4) and the at least one substrate (15) to be processed by the microwave plasma (9).

14. Microwave plasma generating device according to at least one of the preceding claims, **characterized in that** the at least one plasma electrode (8) is arranged at such a distance to the chamber walls (3) and the at least one substrate (15) to be processed that a plasma (20) is formable between the plasma electrode (8) and the at least one substrate (15).

15. Microwave plasma generating device according to claim 14, **characterized in that** the plasma (20) is formable as part of the electrical contact between the plasma electrode (8) and the microwave plasma (9).

16. Microwave plasma generating device according to at least one of the preceding claims, **characterized in that** the microwave plasma generating device (1, 1', 1", 1"', 1"") comprises at least one gas-permeable plasma screen (25) and/or at least one magnet arrangement (26) for shaping the microwave plasma (9).

17. Method for operating a microwave plasma generating device (1, 1', 1", 1"', 1""), wherein the microwaves (µW) of at least one microwave generating device provided outside of the plasma chamber (2, 2') of the microwave plasma generating device (1) are coupled into the plasma chamber (2, 2') by means of at least one microwave incoupling device (29) leading through at least one chamber wall (3) into the plasma chamber (2, 2'), wherein the microwave incoupling device (29) comprises an inner conductor (4) leading into the plasma chamber (2, 2') through at least one chamber wall (3) of the plasma chamber (2, 2'), an insulating tube (5) enclosing the inner conductor (4) and separating the inner conductor (4) from an interior (28) of the plasma chamber (2, 2'), and at least one outer conductor (6, 6') comprising at least one outer conductor end (7), leading into the plasma chamber (2, 2') through the at least one chamber wall (3), provided coaxially but not fully around the inner conductor (4), wherein the inner conductor (5) and the outer conductor (6, 6') form a microwave line and an outlet of microwaves (µW) out of the microwave line in the plasma chamber (2, 2') to generate a microwave plasma (9) in the interior (28) of the plasma chamber (2, 2'), wherein in the interior (28) of the plasma chamber (2, 2'), at least one plasma electrode (8) is provided, which is electrically insulated from the chamber wall (3), to which a DC, NF, or HF voltage is applied and which contacts the microwave plasma (9) electrically, wherein a microwave power is transported in the microwave line and is used for an ionization of the microwave plasma (9),
**characterized in that**
the plasma electrode (8) is arranged coaxially to the inner conductor so that the function of the outer conductor (6, 6') is transferable at least partly to the microwave plasma (9), wherein the electrical potential of the microwave plasma (9) is adjusted by the DC, NF, or HF voltage on the at least one plasma electrode (8).

18. Method according to claim 17, **characterized in that** the electrical potential of the microwave plasma (9) is adjusted relatively to at least one grounded substrate (15) or relatively to at least one substrate (16) being on a bias potential.

## Revendications

1. Dispositif de génération de plasma à micro-ondes (1, 1', 1", 1"', 1"") comprenant une chambre à plasma (2, 2'), au moins un dispositif de génération de micro-ondes pour générer des micro-ondes (µW) situé à l'extérieur de la chambre à plasma (2, 2') et un dispositif de couplage de micro-ondes (29) avec lequel les micro-ondes (µW) peuvent être couplés dans la chambre à plasma (2, 2') ; le dispositif de couplage de micro-ondes (29) comprenant un conducteur intérieur (4) traversant au moins une paroi de chambre (3) de la chambre à plasma (2, 2') et menant dans la chambre à plasma (2, 2'), un tube isolant (5) encerclant le conducteur intérieur (4) et séparant le conducteur intérieur (4) d'un espace intérieur (28) de la chambre à plasma (2, 2'), et un conducteur extérieur (6, 6') traversant la au moins une paroi de chambre (3) et menant dans la chambre à plasma (2, 2 ') prévu coaxialement mais pas complètement tout autour du conducteur intérieur (4) et ayant au moins une extrémité de conducteur extérieur (7) dans la chambre à plasma (2, 2') ; le conducteur intérieur (5) et le conducteur extérieur (6, 6') formant une ligne à micro-ondes, et dans la chambre à plasma (2, 2') une sortie des micro-ondes (µW) de la ligne à micro-ondes pour générer un plasma à micro-ondes (9) est prévu à l'intérieur (28) de la chambre à plasma (2, 2 ') ; au moins une électrode de plasma (8) isolée électriquement et pouvant être sollicitée à tension continue DC, NF ou HF en comparaison avec la paroi de la chambre (3) étant prévu dans l'intérieur (28) de la chambre à plasma (2, 2'), avec laquelle le plasma à micro-ondes (9) peut être mis en contact électrique, **caractérisé en ce que** l'électrode de plasma (8) est arrangée coaxialement au conducteur intérieur de sorte que la fonction du conducteur extérieur (6, 6') peut être transférée au moins partiellement au plasma à micro-ondes (9).

2. Dispositif de génération de plasma à micro-ondes selon la revendication 1, **caractérisé en ce que** le au moins un conducteur extérieur (6, 6') situé dans la région de la paroi de la chambre (3) est mis à la terre.

3. Dispositif de génération de plasma à micro-ondes selon la revendication 1, **caractérisé en ce que** le au moins un conducteur extérieur (6, 6') est connecté à une source de tension alternative (13).

4. Dispositif de génération de plasma à micro-ondes selon l'une des revendications précédentes, **caractérisé en ce que** le au moins un conducteur extérieur (6, 6 ') est arrangé à l'intérieur du tube isolant (5).

5. Dispositif de génération de plasma à micro-ondes selon la revendication 4, **caractérisé en ce que** la au moins une extrémité de conducteur extérieur (7) est une extrémité de tuyau droite.

6. Dispositif de génération de plasma à micro-ondes selon la revendication 4, **caractérisé en ce que** le conducteur extérieur (6') est tubulaire et présent au moins une ouverture à lame (17) qui s'étend dans la direction longitudinale du conducteur extérieur (6').

7. Dispositif de génération de plasma à micro-ondes selon la revendication 1, 2 ou 3, **caractérisé en ce qu'**au moins une partie de la paroi de chambre (3) forme une partie du au moins un conducteur extérieur (6, 6').

8. Dispositif de génération de plasma à micro-ondes selon au moins l'une des revendications précédentes, **caractérisé en ce que** la ligne à micro-ondes traverse par deux parois de chambre (3) opposées et que deux électrodes de plasma (8) sont arrangées sur les parois de chambre (3) opposées dans la chambre de plasma (2, 2'), entre lesquels la formation du plasma à micro-ondes (9) est prévue.

9. Dispositif de génération de plasma à micro-ondes selon au moins l'une des revendications précédentes, **caractérisé en ce qu'**un écran d'espace sombre est prévu autour de la au moins une électrode de plasma (8).

10. Dispositif de génération de plasma à micro-ondes selon au moins l'une des revendications précédentes, **caractérisé en ce que** la au moins une électrode plasma (8) est tubulaire et que une extrémité du tube de l'électrode plasma (8) est prévue comme contact électrique (10) avec le plasma à micro-ondes (9).

11. Dispositif de génération de plasma à micro-ondes selon la revendication 10, **caractérisé en ce que** le rayon d'au moins l'une des extrémités du tube augmente de manière continue, par étapes ou en discontinu.

12. Dispositif de génération de plasma à micro-ondes selon au moins l'une des revendications 1 à 8, **caractérisé en ce que** l'électrode de plasma (8) est un tube de la forme d'un tube continu avec au moins une ouverture d'électrode de plasma (18) s'étendant dans sa direction longitudinale dans la gaine du tube, le plasma à micro-ondes (9) étant prévu dans ladite au moins une ouverture d'électrode de plasma (18).

13. Dispositif de génération de plasma à micro-ondes selon la revendication 12, **caractérisé en ce que** l'ouverture d'électrode de plasma (18) est arrangée entre le conducteur intérieur (4) et au moins un substrat (15) à traiter par le plasma à micro-ondes (9).

14. Dispositif de génération de plasma à micro-ondes selon au moins l'une des revendications précédentes, **caractérisé en ce que** la au moins une électrode de plasma (8) est arrangé à une distance vers les parois de chambre (3) et l'au moins un substrat à traiter (15), de sorte que entre l'électrode de plasma (8) et le au moins un substrat (15) un plasma (20) peut être formé.

15. Dispositif de génération de plasma à micro-ondes selon la revendication 14, **caractérisé en ce que** le plasma (20) peut être formé en tant que partie du contact électrique entre l'électrode de plasma (8) et le plasma à micro-ondes (9).

16. Dispositif de génération de plasma à micro-ondes selon au moins l'une des revendications précédentes, **caractérisé en ce que** le dispositif de génération de plasma à micro-ondes (1, 1', 1", 1"', 1"") présente au moins un écran plasma perméable aux gaz (25) et/ou au moins un agencement magnétique (26) pour conditionner le plasma à micro-ondes (9).

17. Procédé de fonctionnement d'un dispositif de génération de plasma à micro-ondes (1, 1', 1", 1"', 1""), les micro-ondes (µW) d'au moins un dispositif de génération des micro-ondes pourvu à l'extérieur d'une chambre à plasma (2, 2') du dispositif de génération de plasma à micro-ondes (1) étant couplées dans la chambre à plasma (2, 2') à travers d'au moins un dispositif de couplage de micro-ondes (29) traversant au moins une paroi de chambre (3) dans la chambre à plasma (2, 2') ; le dispositif de couplage de micro-ondes (29) présentant un conducteur intérieur (4) traversant au moins une paroi de chambre (3) de la chambre à plasma (2, 2') et menant dans la chambre à plasma (2, 2'), un tube isolant (5) qui encercle le conducteur intérieur (4) et sépare le conducteur intérieur (4) d'un espace intérieur (28) de la chambre à plasma (2, 2'), et un conducteur extérieur (6, 6') traversant la au moins une paroi de chambre (3) menant dans la chambre à plasma (2, 2') prévu coaxialement mais pas complètement tout autour du conducteur intérieur (4) et ayant au moins une extrémité de conducteur extérieur (7) dans la chambre à plasma (2, 2') ; le conducteur intérieur (5) et le conducteur extérieur (6, 6') formant une ligne à micro-ondes et dans la chambre à plasma (2, 2') une sortie des micro-ondes (µW) de la ligne à micro-ondes pour générer un plasma à micro-ondes (9) est prévu à l'intérieur (28) de la chambre à plasma (2, 2') ; au moins une électrode de plasma (8) isolée électriquement et pouvant être sollicitée à tension continue DC, NF ou HF en comparaison avec la paroi de chambre (3) étant prévu dans l'intérieur (28) de la chambre à plasma (2, 2'), avec laquelle le plasma à micro-ondes (9) peut être mis en contact électrique, une puissance à micro-ondes étant transportée dans la ligne à micro-ondes et étant utilisée pour ioniser la **plasma** à micro-ondes (9), **caractérisé en ce que** l' électrode de plasma (8) est arrangée coaxialement au conducteur intérieur de sorte que la fonction du conducteur extérieur (6, 6 ') peut être transférée au moins partiellement au plasma à micro-ondes (9), le potentiel électrique du plasma à micro-ondes (9) étant réglé par la tension DC, NF ou HF sur la au moins une électrode de plasma (8).

18. Procédé selon la revendication 17, **caractérisé en ce que** le potentiel électrique du plasma à micro-ondes (9) est ajusté par rapport à au moins un substrat mis à la terre (15) ou par rapport à au moins un substrat reposant sur un potentiel de polarisation (16).
